Europäisches Patentamt

European Patent Office

Office européen des brevets

(11) Publication number: **0 206 488**
**A1**

## (12) EUROPEAN PATENT APPLICATION

(21) Application number: **86303574.7**

(22) Date of filing: **12.05.86**

(51) Int. Cl.⁴: **G 01 R 31/36**

(30) Priority: **14.05.85 GB 8512137**

(43) Date of publication of application: **30.12.86**
**Bulletin 86/52**

(84) Designated Contracting States: **AT BE CH DE FR GB IT LI LU NL SE**

(71) Applicant: **SALPLEX LIMITED, The Grove Warren Street, Stanmore Middlesex HA7 4LY (GB)**

(72) Inventor: **Hodgkiss, James Arthur, 2 St. ChadsRoad, Eccleshall Staffordshire, ST21 6AH (GB)**
Inventor: **Clarke, Simon Brooks, 4 Cambrian Lane, Rugeley Staffordshire (GB)**

(74) Representative: **Downey, William Gerrard et al, WILSON, GUNN, ELLIS & CO. 41 Royal Exchange Cross Street, Manchester M2 7BD (GB)**

(54) **Method and apparatus for measuring electric current.**

(57) A measurement circuit (8), comprising a filter (9), amplifier (10) and meter (11), is connected to the earth strap of a battery by clips (5 and 6) incorporating Kelvin connections. After calibration, for example using a constant current source (7), the current flowing through the earth strap which is that flowing through the battery load is measured. This provides reliable load current measurement.

-1-

METHOD AND APPARATUS FOR MEASURING ELECTRIC CURRENT

The present invention relates to a method of and apparatus for measuring electric current drawn from a battery, particularly but not exclusively, a vehicle battery. This enables the load currents to be checked to ensure that they are within specified limits.

The existing load current measurement technique uses a clamp on current probe which measures the magnetic field produced by the current from which the load current may be determined. This technique does not give a reliable high resolution measurement, and is subject to a number of problems. These include the clamp not closing properly, strong magnetic fields and drift in the amplifier of the measurement circuit due to the high gains needed.

According to one aspect of the present invention, there is provided apparatus for measuring electric current drawn from a battery comprising a measurement circuit directly electrically connected across the battery earth strap.

According to another aspect of the present invention there is provided a method of measuring electric current drawn from a battery including the steps of directly electrically connecting a measurement circuit

-2-

across the earth strap of the battery, calibrating the circuit and reading off from the calibrated circuit a value representing the current flowing through the strap.

The battery is preferably that of a vehicle such as an automobile. In a preferred form, the direct electrical connections are of clip form and include kelvin connections. The measurement circuit advantageously includes a digital or analogue meter series connected with a filter and amplifier. The circuit may be calibrated by means of a constant current source also connected across the earth strap through the same clips as the measurement circuit. A separate measurement circuit may be provided for measuring the voltage across the battery terminals. If desired, in the case of a vehicle, the wires to the measurement circuit may be incorporated into the vehicle wiring harness and brought out to a diagnostic socket thereby allowing remote current measurement to be made on track during service and at any other time in the vehicle life.

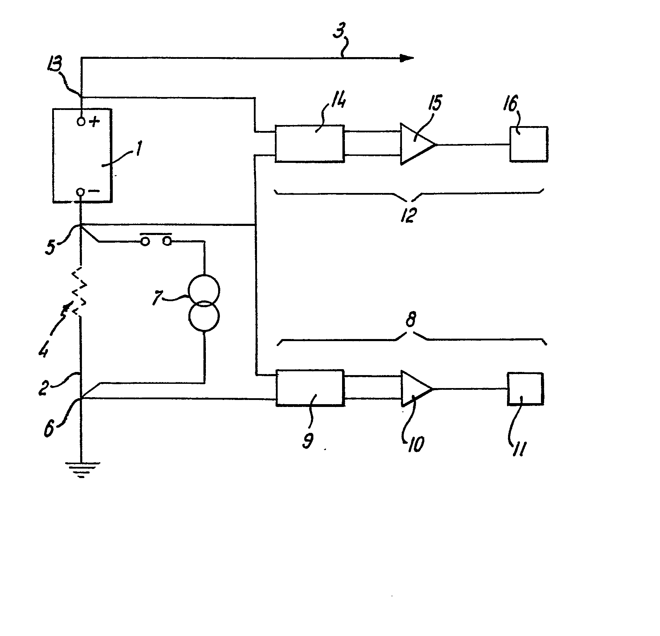

In order that the invention may be more clearly understood, one embodiment thereof will now be described, by way of example, with reference to the single figure of the accompanying drawing which shows a block circuit

-3-

diagram of one form of current measurement according to the present invention.

Referring to the drawing, a vehicle battery 1 is shown connected to earth by an earth strap 2 and to electrical loads by a lead 3.    The battery earth lead resistance is shown in dashed line at 4. A measurement circuit is connected across the earth lead by clamping measuring clips 5 and 6 incorporating Kelvin connections.   A constant current source 7 is also connected across the earth strap by means of the same clamping measuring clips 5 and 6. The measurement circuit 8 comprises a filter 9, amplifier 10 and meter 11·    The filter is operative to filter out stray signals, for example from a mains supply, which would otherwise result in an inaccurate measurement.   The meter may be analogue or digital.

A battery voltage measurement circuit 12 is also provided.  This is connected across the battery, also by clamping measuring clips incorporating Kelvin connections.   One of the clips is the clip 5. The other clips is referenced 13.   The voltage measurement circuit also comprises a filter 14 for filtering out stray signals, an amplifier 15 and a digital or analogue meter 16.

-4-

The current measurement circuit 8 of the arrangement may be calibrated using the constant current source 7. A known current is supplied through the resistor 4 and the voltage picked off through the Kelvin connections thus enabling the meter to be calibrated against the known current.

In normal use of the arrangement, the current to the load, which flows through the earth strap, may be measured by this calibrated meter. The battery voltage may also be measured by the voltage measurement circuit 12.

The above arrangement has been described by way of example only and many variations are possible, without departing from the scope of the invention. The measurement wires to the Kelvin connections may be incorporated into the main vehicle wiring harness and brought out into one diagnostic socket thereby allowing remote current measurement to be made on track during service or at any other time during the life of the vehicle. Calibration may be effected by measuring the voltage across the earth strap for several known value loads in the vehicle circuitry. With such an arrangement an external current source such as the constant current generator described above would not be necessary.

-5-

<u>CLAIMS</u>

1. Apparatus for measuring electric current drawn from a battery (1) characterised by a measurement circuit (8) directly electrically connected across the battery earth strap (2).

2. Apparatus as claimed in claim 1, in which the direct electrical connections are of clip form (5,6) and include Kelvin connections.

3. Apparatus as claimed in claim 1 or 2, in which the measurement circuit (8) advantageously includes a digital meter (11) series connected with a filter (9) and amplifier (10).

4. Apparatus as claimed in claim 1 or 2, in which the measurement circuit (8) advantageously includes an analogue meter series connected with a filter (9) and amplifier (10).

5. Apparatus as claimed in any preceding claim, in which a further measurement circuit (12) is provided for measuring the voltage across the battery terminals.

6. Apparatus as claimed in claim 5, in which the further measurement circuit comprises a filter (14) an amplifier

-6-

(15) and a digital meter (16).


8.    Apparatus as claimed in any preceding claim in which an output from the measurement circuit (8) may be incorporated into the vehicle wiring harness and brought out to a diagnostic socket.


9.    A method of measuring electric current drawn from a battery including the steps of directly electrically connecting a measurement circuit (8) across the earth strap (2) of the battery (1), calibrating the circuit and reading off from the calibrated circuit a value representing the current flowing through the strap (2).


10.   A method as claimed in claim 9, in which calibration is effected using a constant current source to supply a known current through the load.


11.   A method as claimed in claim 9, in which calibration is effected by measuring the voltage across the earth strap for several known value loads in vehicle circuitry for which the battery is provided.

0 206 488

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 617 850 (E.H. DOMSHY) * Column 2, line 65 - column 3, line 5; figure 1 * | 1 | G 01 R 31/36 |
| A | | 2-4,8 | |
| | --- | | |
| X | US-A-3 895 284 (SCHWEIZER et al.) * Column 4, line 27 - column 5, line 26; figure 1 * | 1 | |
| | --- | | |
| A | US-A-3 985 284 | 3,4 | |
| | --- | | |
| Y | DE-A-3 116 371 (GOTTFRIED HAGEN) * Page 4, line 23 - page 6, line 5; figure * | 1,3,5, 6 | |
| A | | 4 | TECHNICAL FIELDS SEARCHED (Int. Cl.4) G 01 R H 01 M |
| | --- | | |
| Y | US-A-3 401 337 (C.C. BEUSMAN et al.) * Column 3, line 67 - column 4, line 37; figures 1-3 * | 1,3,5, 6 | |
| A | | 2,8 | |
| | --- -/- | | |

The present search report has been drawn up for all claims

| Place of search | Date of completion of the search | Examiner |
|---|---|---|
| THE HAGUE | 22-08-1986 | ROSE A.R.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| A | FR-A-2 529 020 (MITSUBISHI DENKI) <br> * Page 3, lines 18-27; claim 1; figure * | 1,3,5,6 | |
| | --- | | |
| A | GB-A- 640 207 (CHARLES H. BURGESS) <br> * Page 2, line 95 - page 3, line 1; figure; claim 1 * | 1,5,8 | |
| | ----- | | |

TECHNICAL FIELDS SEARCHED (Int. Cl.4)

The present search report has been drawn up for all claims

| Place of search | Date of completion of the search | Examiner |
|---|---|---|
| THE HAGUE | 22-08-1986 | ROSE A.R.P. |